# EUROPÄISCHE PATENTSCHRIFT

(11) **EP 0 778 954 B1**
(45) Veröffentlichungstag und Bekanntmachung des Hinweises auf die Patenterteilung: **13.01.1999**
(21) Anmeldenummer: 95929728.4
(22) Anmeldetag: 31.08.1995
(51) Int. Cl.: G01V 3/08, H03K 17/95

(54) **NÄHERUNGSSCHALTER MIT MAGNETFELDEMPFINDLICHEM SENSOR**
PROXIMITY SWITCH WITH MAGNETIC FIELD-SENSITIVE SENSOR
DECLENCHEUR DE PROXIMITE POURVU D'UN DETECTEUR SENSIBLE AU CHAMP MAGNETIQUE

(30) Priorität: 31.08.1994 DE 9414104 U
(43) Veröffentlichungstag der Anmeldung: 18.06.1997
(73) Patentinhaber: SIEMENS AKTIENGESELLSCHAFT, 80333 München (DE)
(72) Erfinder: JANSSEUNE, Luc, B-8400 Oostende (BE)
(86) Internationale Anmeldenummer: DE9501173
(87) Internationale Veröffentlichungsnummer: WO9607112

(56) Entgegenhaltungen:
- EP-A- 0 464 892
- DE-A- 3 426 784
- DE-A- 3 901 678
- US-A- 4 745 363
- US-A- 5 137 677

## Beschreibung

Die Erfindung betrifft einen Näherungsschalter mit magnetfeldempfindlichem Sensor.

Konventionelle mechanische Schalter werden, insbesondere bei Kfz-Anwendungen, zunehmend durch berührungslose Näherungsschalter mit einem magnetfeldempfindlichen Sensor, beispielsweise einem Hall-Sensor oder einem Magnetoresistor, abgelöst. Hall-Sensoren bestehen im Prinzip aus einer mit Konstantstrom versorgten Halbleiterschicht, insbesondere aus Silizium. Durch eine Magnetfeldkomponente senkrecht zur Schicht wird der Konstantstrom beeinflußt und der Sensor liefert eine auswertbare Hall-Spannung, die proportional zur anliegenden Magnetfeldstärke ist. Hall-Sensoren werden gegenwärtig zweckmäßigerweise in Form eines integrierten Schaltkreises verwendet, der bereits eine zur Auswertung des Schaltungszustandes geeignete Auswerteschaltung enthält.

Aus der DE-OS 39 01 678 ist es bekannt, den magnetfeldempfindlichen Sensor in eine magnetfeldfreie Zone einer speziellen Permanent-Magnet-Anordnung zu positionieren. Zur Erzielung einer hohen Temperaturstabilität wird der Dauermagnet bei dem bekannten Näherungsschalter deshalb so gestaltet, daß eine ringförmige Polfläche gegeben ist. Die Ansteuerung durch ein flächiges ferromagnetisches Auslöseteil erfolgt dabei senkrecht zur Polebene, wobei die magnetfeldfreie Zone bei Annäherung nicht aufgehoben wird, sondern nur vom Sensor wegwandert.

Bei der aus US-A-4 745 363 bekannten Anordnung zur Detektion der Zähne eines sich drehenden Zahnrades mittels eines Magneten und eines Hall-Elementes ragt das Hall-Element aus einer Nut am Magneten heraus. Um eine ausreichende Empfindlichkeit der Meßanordnung zu gewährleisten, sind zusätzliche Maßnahmen zur Konzentration des Magnetfeldes im Bereich des Hall-Elementes notwendig. Die Empfindlichkeit der Meßanordnung ist dort außerdem stark von der genauen Position des Hall-Elementes abhängig.

In DE-A-3 426 784 ist ein magnetoresistiver Sensor beschrieben, bei dem das Sensorelement außerhalb eines U-förmigen Permanentmagneten angeordnet ist. Bei Annäherung eines Auslöseelementes an das Sensorelement wird die Änderung der Tangentialkomponente des magnetischen Flusses, welcher das Sensorelement durchsetzt, erfaßt und ausgewertet.

Bei der in EP-A-0 464 892 beschriebenen Anordnung zum Detektieren eines bewegten ferromagnetischen Elementes ist die Sensorsignalspannung während der Annäherung eines Meßobjektes an das Sensorelement in einem weiten Bereich verschwindend. Dies kann sich ungünstig auf eine ausreichende Empfindlichkeit der Sensoranordnung auswirken, wobei eine Realisierung anwendungsspezifischer Schaltabstände problematisch erscheint.

Aufgabe der vorliegenden Erfindung ist es, einen Näherungsschalter mit magnetfeldempfindlichem Sensor zu schaffen, der besonders einfach aufgebaut und sehr einfach herzustellen ist.

Erfindungsgemäß wird diese Aufgabe gelöst durch einen Näherungsschalter mit magnetfeldempfindlichem Sensor,
- mit einem U-förmigen Dauermagnet mit vertikaler Magnetisierungsrichtung,
- wobei zwischen den Schenkeln des U's durch drei gleichnamige, einander abstoßende Pole ein magnetflußfreier Bereich gebildet ist, in dem der magnetfeldempfindliche Sensor angebracht ist,
- und mit einem oberhalb der U-Schenkel in einer zur Basis des U parallelen Ebene annäherbaren flächigen ferromagnetischen Auslöseteil,
- wobei bei Annäherung des Auslöseteils an die beiden Pole der U-Schenkel ein durch Aufhebung des magnetflußfreien Bereiches ausgelöstes Schaltsignal des Sensors auswertbar ist.

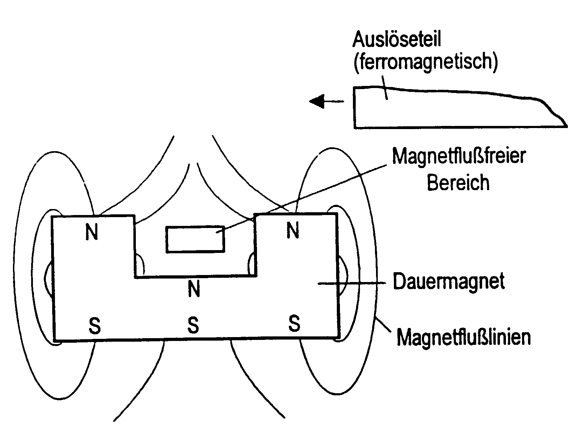

Vorteilhafte Ausgestaltungen des Gegenstandes des Anspruchs 1 sind in den abhängigen Ansprüchen angegeben. Die Erfindung wird im folgenden anhand des in der einzigen Figur der Zeichnung dargestellten Ausführungsbeispiels noch näher erläutert. Die Figur zeigt in Seitenansicht ein Magnetsystem eines erfindungsgemäßen Näherungsschalters.

In der Figur ist ein U-förmiger Magnet mit vertikaler Magnetisierungsrichtung dargestellt. Zwischen den Schenkeln des U's befindet sich ein magnetflußfreier Bereich, da die drei Nordpole einander abstoßen. In diesem Bereich wird ein magnetfeldempfindlicher Sensor angebracht. Wenn ein ferromagnetisches Auslöseteil oberhalb des Magneten in der angedeuteten Ebene an den U-förmigen Magneten angenähert wird, so werden die zwei seitlichen Nordpole teilweise abgeschirmt bzw. es wird deren Magnetfeld abgelenkt. Der Magnetfluß des mittleren Nordpols kann sich daraufhin besser durchsetzen, fließt also durch den Magnetfeldsensor, und löst damit ein Schaltsignal aus.

Die dargestellte Anordnung ist besonders einfach aufgebaut und platzsparend. Vorteilhaft ist auch, daß aus der besonderen geometrischen Ausgestaltung des Magnetsystems eine Abschirmung des Sensors nach drei Seiten resultiert. Eine verringerte magnetische Störanfälligkeit des Sensors ist beispielsweise bei Anwendungen des Näherungsschalters in KfzZentralverriegelungen von Bedeutung.

Ein versuchsweise aufgebauter Schalter wies bei Abmessungen von jeweils 4mm für die Dicke des Magneten und für die Breiten der U-Schenkel und des Bereichs zwischen den Schenkeln bereits einen Schaltabstand von 1,5mm auf. Dieser Schaltabstand kann durch geeignete Bestimmung der Abmessungen des U-Magneten ohne weiteres noch optimiert, also vergrößert werden. Ein relativ großer Schaltabstand ist erwünscht, da in der Praxis zwischen dem beispielsweise in einem Schloß eingebauten Näherungsschalter und dem Auslöseteil Toleranzen auftreten, die bei zu geringem Schaltabstand zu einem zu großen Abstand zwischen dem angenäherten Auslöseteil und dem Schalter führen können.

Ein erfindungsgemäßer Näherungsschalter, der sich dadurch auszeichnet, daß der Näherungsschalter ein aus thermoplastischem Kunststoff bestehendes Gehäuse für den Dauermagnet umfaßt, daß der Dauermagnet aus einem kunststoffgebundenen Dauermagnetpulver besteht, daß der Dauermagnet und das Gehäuse in Zwei-Komponenten-Spritztechnik hergestellt sind, wobei das Gehäuse unmittelbar an dem Dauermagneten angespritzt ist, und daß der Dauermagnet nach dem Umspritzen magnetisiert ist, ist besonders kostengünstig herstellbar. Beispielsweise wird dabei zunächst der U-Magnet gespritzt, der anschließend mit dem Gehäuse umspritzt wird.Die beiden Komponenten werden also in ein und derselben Spritzmaschine nacheinander ausgeformt. Dies ist besonders einfach durchführbar, wenn für das Gehäuse und den Dauermagneten verschiedene Kunststoffe verwendet werden. Auch bei gleichen Kunststoffen kann der theoretischen Gefahr einer Wiederaufweichung einer zuvor gespritzen Komponente durch entsprechende Anpassung der Spritzparameter und Spritzzykluszeiten begegnet werden, so daß die einzelnen Komponenten nacheinander ausformen und ohne ein Verkleben der Komponenten aneinander angespritzt werden können.

Die wesentlichen Schritte des Herstellungsvorganges können beispielsweise so erfolgen, daß ein Kupferband gestanzt und anschließend galvanisiert wird, daß auf einer Seite Hall-Chips mit zwei bis drei Anschlüssen beispielsweise direkt gebondet werden und daß dieses bestückte Kupferband anschließend in eine Spritzmaschine läuft. Dort werden nacheinander das kunststoffgebundene Dauermagnetpulver, beispielsweise Polyestergranulat und anschließend das Gehäuse mit eingespritzter Platine gespritzt. Der Magnetfeldsensor wird entweder in das Gehäuse mit eingespritzt oder nachträglich eingesetzt.

## Patentansprüche

1. Näherungsschalter mit magnetfeldempfindlichem Sensor,
- mit einem U-förmigen Dauermagnet mit vertikaler Magnetisierungsrichtung,
- wobei zwischen den Schenkeln des U's durch drei gleichnamige, einander abstoßende Pole ein magnetflußfreier Bereich gebildet ist, in dem der magnetfeldempfindliche Sensor angebracht ist,
- und mit einem oberhalb der U-Schenkel in einer zur Basis des U parallelen Ebene annäherbaren flächigen ferromagnetischen Auslöseteil,
- wobei bei Annäherung des Auslöseteils an die beiden Pole der U-Schenkel ein durch Aufhebung des magnetflußfreien Bereiches ausgelöstes Schaltsignal des Sensors auswertbar ist.

2. Näherungsschalter nach Anspruch 1,
**dadurch gekennzeichnet**, daß der Näherungsschalter ein aus thermoplastischem Kunststoff bestehendes Gehäuse für den Dauermagnet umfaßt,
daß der Dauermagnet aus einem kunststoffgebundenen Dauermagnetpulver besteht,
daß der Dauermagnet und das Gehäuse in Zwei-Komponenten-Spritztechnik hergestellt sind, wobei das Gehäuse unmittelbar an dem Dauermagnet angespritzt ist,
und daß der Dauermagnet nach dem Umspritzen magnetisiert ist.

3. Näherungsschalter nach Anspruch 2,
**dadurch gekennzeichnet**, daß der magnetfeldempfindliche Sensor in das Gehäuse mit eingespritzt oder nachträglich eingesetzt ist.

## Claims

1. Proximity switch having a magnetic field-sensitive sensor,
- having a U-shaped permanent magnet with vertical direction of magnetization,
- a magnetic flux-free region, in which the magnetic field-sensitive sensor is fitted, being formed between the limbs of the U by three like, mutually repelling poles,
- and having a flat ferromagnetic triggering part which can be brought close above the limbs of the U in a plane parallel to the base of the U,
- a switching signal which is triggered from the sensor by the cancellation of the magnetic flux-free region when the triggering part is brought close to the two poles of the limbs of the U being able to be evaluated.

2. Proximity switch according to Claim 1, characterized in that the proximity switch comprises a housing which is composed of thermoplastic for the permanent magnet,
in that the permanent magnet is composed of a plastic-bonded permanent magnet powder,
in that the permanent magnet and the housing are produced using two-component injection-moulding technology, the housing being moulded directly onto the permanent magnet,
and in that the permanent magnet is magnetized after the encapsulation.

3. Proximity switch according to Claim 2, characterized in that the magnetic field-sensitive sensor is moulded into the housing at the same time or is subsequently inserted.

## Revendications

1. Déclencheur de proximité pourvu d'un détecteur sensible au champ magnétique,
- avec un aimant permanent en forme de U avec une direction d'aimantation verticale,
- pour lequel un domaine sans flux magnétique est formé entre les branches du U par l'intermédiaire de trois pôles, de même polarité, se repoussant les uns les autres, domaine dans lequel un détecteur sensible au champ magnétique est mis en place,
- et avec un élément de déclenchement ferromagnétique plan rapprochable au dessus des branches du U, dans un plan parallèle par rapport à la base du U,
- pour lequel lors du rapprochement de l'élément de déclenchement au niveau des deux pôles des branches du U, un signal de commutation du détecteur, déclenché par l'intermédiaire de la neutralisation du domaine sans flux magnétique, pouvant être évalué.

2. Déclencheur de proximité selon la revendication 1,
caractérisé en ce que le déclencheur de proximité comprend pour l'aimant permanent un boîtier se composant de matière synthétique thermoplastique, en ce que l'aimant permanent se compose d'une poudre magnétique permanente liée dans une matière synthéthique,
en ce que l'aimant permanent et le boîtier sont fabriqués par la technique d'injection à deux composants, le boîtier étant moulé directement contre l'aimant permanent,
et en ce que l'aimant permanent est aimanté après l'extrusion.

3. Déclencheur de proximité selon la revendication 2,
caractérisé en ce que le détecteur sensible au champ magnétique est injecté simultanément dans le boîtier ou mis en place ultérieurement.
